# EUROPÄISCHE PATENTSCHRIFT

(11) **EP 1 978 132 B1**
(45) Veröffentlichungstag und Bekanntmachung des Hinweises auf die Patenterteilung: **03.12.2014**
(21) Anmeldenummer: 08101646.1
(22) Anmeldetag: 15.02.2008
(51) Int. Cl.: C22C 1/05, C22C 1/10, C22C 29/00, H01L 29/423, C23C 24/08, C23C 26/00, G01N 27/414, H01L 29/772, C23C 24/00, B22F 1/02

(54) **Verfahren zur Herstellung einer porösen Schicht**
Method for producing a porous layer
Procédé destiné à la fabrication d'une couche poreuse

(30) Priorität: 02.04.2007 DE 102007015874
(43) Veröffentlichungstag der Anmeldung: 08.10.2008
(73) Patentinhaber: ROBERT BOSCH GMBH, 70442 Stuttgart (DE)
(72) Erfinder: Wolst, Oliver, 72622 Nuertingen (DE); Widenmeyer, Markus, 71101 Schoenaich (DE); Martin, Alexander, 70469 Stuttgart (DE)

(56) Entgegenhaltungen:
- WO-A1-2008/043781
- DE-A1- 10 003 982
- US-A- 4 073 999
- US-A1- 2005 061 107

## Beschreibung

### Stand der Technik

Die Erfindung betrifft ein Verfahren zur Herstellung einer porösen Schicht auf einem Substrat, wobei die poröse Schicht mindestens ein keramisches Material und mindestens ein Metall enthält. Derartige poröse Strukturen werden zum Beispiel als Gateelektroden von Halbleiter-Feldeffekttransistoren eingesetzt. Die Feldeffekttransistoren mit poröser Gateelektrode können zum Beispiel als Gassensoren eingesetzt werden. Die poröse metallische Gateelektrode wird zum Beispiel durch nasschemische Abscheidung von Nanomaterialien hergestellt. Aus Nanomaterialien hergestellte Gateelektroden zeigen eine höhere thermische Stabilität und eine höhere Gasempfindlichkeit als Elektroden, die aufgedampft wurden. Jedoch wird insbesondere bei höheren Temperaturen häufig ein Zusammenlaufen von Metallkolloiden bzw. porösen Metallstrukturen auf einer oxidischen Oberfläche des Feldeffekttransistors beobachtet. Hierdurch verringert sich die Sensitivität des Sensors gegenüber Messgasen. Durch zusammenlaufende Metallkolloide sinkt weiterhin die Lebensdauer des Gassensors.

Aus US 4,931,851 ist ein Feldeffekttransistor bekannt, der eine Gateelektrode aus einem Cermet aus Platin und Siliziumdioxid aufweist. Die Gateelektrode wird zum Beispiel durch Sputtern hergestellt.

Weitere relevante Verfahren zur Abscheidung von porösen Keramikschichten auf Substraten sind den Druckschriften WO 2008/043781 A1 sowie US 4 073 999 A zu entnehmen.

### Offenbarung der Erfindung

### Vorteile der Erfindung

Das erfindungsgemäße Verfahren zur Herstellung einer porösen Schicht auf einem Substrat, wobei die poröse Schicht mindestens ein keramisches Material und mindestens ein Metall enthält, umfasst folgende Schritte:
(a) Auftragen einer Dispersion, die mindestens einen Metallbildner und mindestens einen Keramikbildner enthält, auf das Substrat, wobei der Metallbildner in Form von Metallpartikeln und/oder der Keramikbildner in Form von Partikeln aus einem keramischen Material in der Dispersion enthalten ist,
(b) Überführen der Dispersion bei einer Temperatur oberhalb von 250°C in eine Cermet-Beschichtung.

Vorteil der nach dem erfindungsgemäßen Verfahren hergestellten Cermet-Schicht ist, dass diese sich auch bei hohen Temperaturen nicht verändert. So zeigt sich zum Beispiel auch bei einer Behandlung bei 400°C kein Zusammenlaufen der Schicht. Ein weiterer Vorteil der erfindungsgemäß hergestellten Schicht ist, dass diese elektrisch leitfähig ist.

Die Dispersion, die auf das Substrat aufgetragen wird, ist vorzugsweise flüssig oder pastös. Die Viskosität der Dispersion wird dabei zum Beispiel durch mindestens ein Lösungsmittel eingestellt. Weiterhin kann die Dispersion Additive enthalten. Derartige Additive sind zum Beispiel Tenside, Stabilisatoren, Dispergatoren oder Porenbildner.

Das Lösungsmittel kann jedes beliebige, dem Fachmann bekannte Lösungsmittel sein. Bevorzugte Lösungsmittel sind polar aprotische Lösungsmittel, Alkohole, Glykol- oder Glycerinderivate und deren Derivate. Geeignete Stabilisatoren sind zum Beispiel Glykolderivate, zum Beispiel Diethylenglykolmonobutylether oder Trioxadekansäure.

Als Porenbildner eigenen sich alle Substanzen, die zum Beispiel durch Pyrolyse oder Auslösen entfernt werden können. Geeignete Porenbildner sind zum Beispiel Russpartikel, Latexteilchen oder organische Polymere.

In einer Ausführungsform ist der Metallbildner zumindest teilweise als mindestens ein Metallsalz oder eine salzhaltige Vorstufe, die durch die thermische Behandlung in das mindestens eine Metall umgewandelt wird, in der Dispersion enthalten. Die Metallsalze oder salzartigen Vorstufen können dabei zum Beispiel im Lösungsmittel gelöst oder fein verteilt vorliegen. Bevorzugt liegt der Metallbildner jedoch in Form von Metallpartikeln in der Dispersion vor.

Der Keramikbildner kann zum Beispiel ebenfalls in Form von Partikeln aus einem keramischen Material in der Dispersion enthalten sein. Wenn sowohl der Metallbildner als auch der Keramikbildner in Form von Partikeln in der Dispersion enthalten sind, spricht man auch von separierten Teilchen bzw. separierten Substanzen. Wenn der Metallbildner und der Keramikbildner als separierte Teilchen bzw. Substanzen vorliegen, ist es möglich, dass ein Teil des Metallbildners oder des Keramikbildners als Salz oder salzartige Vorstufe, die im Lösungsmittel gelöst oder fein verteilt ist, vorliegt. Es ist jedoch erforderlich, dass mindestens ein Teil des Metallbildners oder ein Teil des Keramikbildners als feinverteilte Partikel aus keramischem Material bzw. als Metallpartikel vorliegen.

Weiterhin ist es auch möglich, dass der Metallbildner und der Keramikbildner als so bezeichnete vergesellschaftete Teilchen vorliegen. In diesem Fall befindet sich der Keramikbildner zumindest teilweise an der Oberfläche der Partikel des mindestens einen Metalls. Alternativ ist es auch möglich, dass sich der Metallbildner an der Oberfläche der Keramikpartikel befindet.

Die Komponente, die sich auf der Oberfläche der anderen Komponente befindet, kann zum Beispiel in Form kleiner, überwiegend getrennter Teilchen auf der Oberfläche der anderen Komponente vorliegen. Alternativ ist es auch möglich, dass die äußere Komponente die innere Komponente schalenartig umschließt. Dabei kann die äußere Komponente die innere Komponente entweder vollständig oder unvollständig umschließen.

Weiterhin ist es auch möglich, dass eine Komponente als Partikel vorliegt, wobei die Partikel Poren aufweisen. Diese Komponente kann entweder der Metallbildner oder der Keramikbildner sein. Die andere Komponente befindet sich in den Poren der ersten Komponente. Wenn also Metallpartikel mit Poren vorliegen, so ist das keramische Material in den Poren der Metallpartikel enthalten. Entsprechend ist bei Vorliegen von Keramikpartikeln mit Poren der Metallbildner in den Poren der Keramikpartikel enthalten.

In einer dritten Form der vergesellschafteten Teilchen liegen beide Komponenten, das heißt sowohl der Keramikbildner als auch der Metallbildner gemeinschaftlich in assoziierten Verbänden mehrerer primärer Teilchen vor.

Diese verschiedenen Typen der Vergesellschaftung bilden in der Realität oftmals fließende Übergänge und Mischformen, die von der Erfindung mit umfasst werden. Zusätzlich zu dem keramischen Material und dem Metall können auch salzartige Keramik- bzw. Metallbildner an der Vergesellschaftung teilhaben.

Der Keramikbildner ist zum Beispiel ein keramisches Material. Alternativ ist es auch möglich, dass der Keramikbildner mindestens ein weiteres Metall ist, welches als Oxid das keramische Material bildet. In diesem Fall bildet sich das keramische Material zum Beispiel bei der thermischen Behandlung, wenn die Dispersion in Gegenwart von Sauerstoff, zum Beispiel aus der Luft, erwärmt wird.

Die Partikel des Metallbildners bzw. des Keramikbildners haben vorzugsweise einen mittleren Durchmesser im Bereich von 5 bis 250 nm.

Neben der oben beschriebenen Vergesellschaftung, bei der der Keramikbildner und der Metallbildner gemeinsam Partikel bilden, ist es auch möglich, dass sich zum Beispiel kleine Keramikpartikel oder kleine Metallpartikel auf größeren Partikeln derselben Substanz befinden.

Wenn die Dispersion als Flüssigkeit, das heißt als Lack, auf das Substrat aufgetragen wird, enthält diese vorzugsweise im Bereich zwischen 0,1 und 5 Vol.-% Metallbildner und Keramikbildner. Wenn die Dispersion als Paste aufgetragen wird, liegt der Anteil an Metallpartikeln und Keramikpartikeln vorzugsweise im Bereich zwischen 5 und 60 Vol.-%. Der Anteil an keramischem Material in der Dispersion beträgt vorzugsweise 1 bis 40 Vol.-%.

Nach dem Auftragen der Dispersion wird diese in eine Cermet-Beschichtung überführt. Dies erfolgt im Allgemeinen bei einer Temperatur oberhalb von 250°C. Bevorzugt liegt die Temperatur dabei im Bereich zwischen 400 und 600°C.

### Kurze Beschreibung der Zeichnungen

Ausführungsformen der Erfindung sind in den Zeichnungen dargestellt und in der nachfolgenden Beschreibung näher erläutert.

Es zeigen
- Figur 1: eine Cermet-Schicht auf einem Substrat,
- Figur 2: einen Schichtaufbau eines Feldeffekttransistors.

### Ausführungsformen der Erfindung

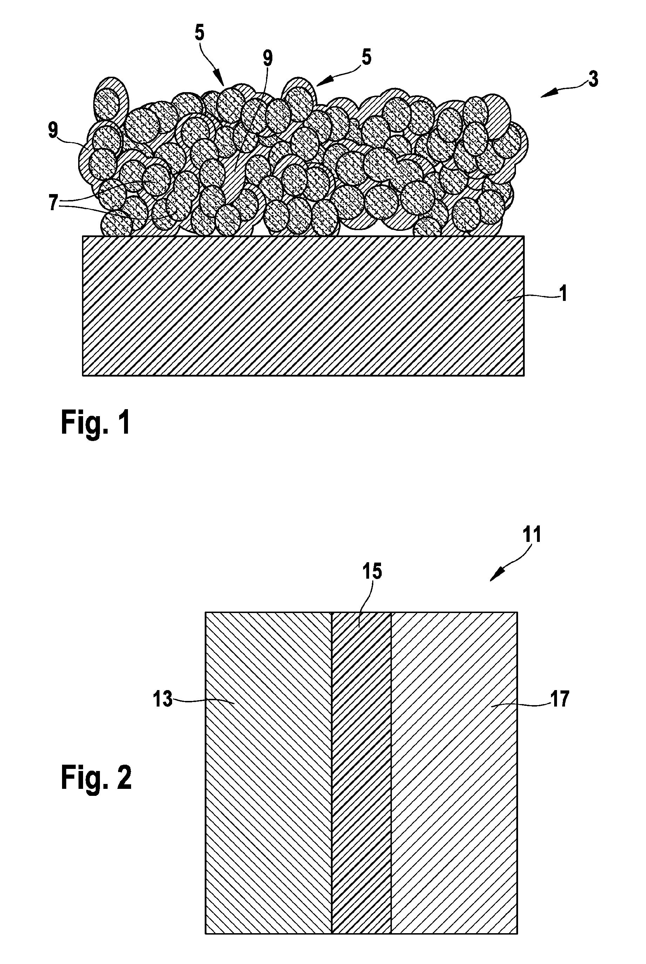

In Figur 1 ist eine Cermet-Schicht auf einem Substrat dargestellt.

Auf ein Substrat 1 ist eine poröse Schicht 3 aufgebracht. In der hier dargestellten Ausführungsform ist die poröse Schicht 3 aus Partikeln 5 aufgebaut, die eine poröse Cermet-Beschichtung bilden. Die Cermet-Beschichtung enthält hierzu ein keramisches Material 7 und ein metallisches Material 9. Das metallische Material kann sich zum Beispiel, wie hier dargestellt, an der Oberfläche der Keramikpartikel 7 befinden. Alternativ ist es jedoch auch möglich, dass sich das keramische Material an der Oberfläche von Metallpartikeln befindet. Die Komponente, die sich an der Oberfläche der anderen Komponente befindet kann zum Beispiel in Form kleiner, überwiegend getrennter Teilchen auf der Oberfläche der anderen Komponente vorliegen. Alternativ ist es auch möglich, dass die äußere Komponente die innere Komponente schalenartig vollständig oder unvollständig umschließt.

In einer alternativen Ausführungsform können die Keramikpartikel 7 und das metallische Material 9 auch gemeinschaftlich in assoziierten Verbänden mehrerer primärer Teilchen vorliegen. Weiterhin ist es auch möglich, dass eine Komponente, entweder das keramische Material oder das metallische Material Poren enthält, in denen sich die andere Komponente befindet. Im Allgemeinen treten Mischformen aus allen drei Variationen auf.

Zur Herstellung der porösen Schicht 3 wird üblicherweise eine Dispersion, die mindestens einen Metallbildner und mindestens einen Keramikbildner enthält, auf das Substrat 1 aufgetragen, wobei zumindest ein Teil des Metallbildners in Form von Metallpartikeln und/oder zumindest ein Teil des Keramikbildners in Form von Keramikpartikeln in der Dispersion enthalten ist. Das Auftragen der Dispersion kann dabei mit jedem beliebigen, dem Fachmann bekannten Verfahren erfolgen. Hierzu kann die Dispersion zum Beispiel flüssig oder pastös vorliegen. Die Viskosität der Dispersion wird im Allgemeinen über ein Lösungsmittel eingestellt. Um eine flüssige Dispersion zu erzielen, ist der Anteil an Lösungsmittel höher als bei einer pastösen Dispersion.

Als Metallbildner sind in der Dispersion zum Beispiel Metallsalze oder salzartige Vorstufen des Metalles enthalten, die zum Beispiel durch thermische Behandlung in das Metall der Cemert-Beschichtung umgewandelt werden. Geeignete Metalle sind zum Beispiele Metalle der achten, neunten oder zehnten Gruppe des Periodensystems der Elemente. Bevorzugte Metalle sind Platin oder Gold.

Als Keramikbildner in der Dispersion eignen sich zum Beispiel ebenfalls Metalle, die in Form eines Metallsalzes in der Dispersion vorliegen können. Im Allgemeinen wird das Metall des Keramikbildners durch Oxidation mit Sauerstoff in die entsprechende Keramik umgewandelt. Zusätzlich ist es jedoch auch möglich, dass in der Dispersion bereits Keramikpartikel enthalten sind.

Geeignete Keramiken sind zum Beispiel SiO₂ und Al₂O₃.

Durch eine thermische Behandlung bei einer Temperatur oberhalb von 250°C wird die Dispersion in die Cermet-Beschichtung umgewandelt.

Um zusätzliche Poren in der porösen Schicht 3 zu erhalten, kann die Dispersion, die in die Cermet-Beschichtung umgewandelt wird, Porenbildner enthalten. Als Porenbildner eignen sich zum Beispiel Rußpartikel, Latexteilchen oder organische Polymere, die bei der Temperatur, bei der die thermische Behandlung durchgeführt wird, verbrennen.

Die als Cermet-Beschichtung ausgebildete poröse Schicht 3 eignet sich zum Beispiel als Gate-Elektrode eines Feldeffekt-Transistors. Vorteil des Cermet-Materials ist, dass dieses aufgrund des darin enthaltenen Metalls elektrisch leitfähig ist. Auch ist eine Cermet-Beschichtung temperaturstabil und kann bei Temperaturen oberhalb von 400°C eingesetzt werden.

Eine stabile und oberflächenreiche Cermet-Schicht wird dadurch erzeugt, indem Cermet-Bildner als Dispersion, dem so genannten Cermet-Lack, auf einen Träger aufgebracht wird. Als Beimengung können in der Dispersion salzartige Cermet-Bildner vorhanden sein. Jedoch ist es erforderlich, dass zumindest eine Komponente des Cermet-Bildners zumindest teilweise als fein verteilte Keramik bzw. als fein verteiltes Metall vorliegt. Der Keramikbildner kann ebenso als Metall vorliegen, das bei der thermischen Behandlung in oxidierender Atmosphäre in dioxidische Keramik überführt werden kann. Die Cermet-Bildner können dabei als voneinander separierte Teilchen bzw. Substanzen, als miteinander vergesellschaftete Teilchen oder teilweise als Salze oder salzartige Vorstufen vorliegen.

Das Substrat 1 ist zum Beispiel ein Gate-Substrat eines Feldeffekttransistors.

In Figur 2 ist ein Schichtaufbau eines Feldeffekttransistors schematisch dargestellt.

Ein Feldeffekttransistor 11 umfasst eine Source 13, ein Gate-Substrat 15 und einen Drain 17. Sowohl die Source 13, das Gate-Substrat 15 als auch der Drain 17 können als Cermet-Schicht ausgeführt sein. Bevorzugt ist nur das Gate-Substrat 15 als Cermet-Schicht ausgebildet.

Derartige Feldeffekttransistoren 11 können zum Beispiel in Gassensoren eingesetzt werden. Hierzu ist es erforderlich, dass die poröse Schicht, die als Gate-Beschichtung ausgebildet ist, eine große Oberfläche aufweist. Das bedeutet, dass zum einen die Gesamtoberfläche der porösen Schicht 3 groß ist und zum anderen ein großer Anteil an 3-Phasen-Grenzen enthalten ist, das heißt Phasengrenzen, an denen die keramische, die metallische und Gasphase unmittelbar aneinander angrenzen.

Eine erfindungsgemäß ausgebildete poröse Schicht wird zum Beispiel hergestellt, indem eine Lösung aus 2 Gew.-% Platin, 0,5 Gew.-% ZrO₂ in einem Lösungsmittelgemisch, zum Beispiel aus Tetrahydrofuran, Diethylether, Monobutyldiethylenglykolether, gelöst sind. Die gelösten Platinteilchen haben bevorzugt einen Durchmesser im Bereich von 10 bis 100 nm, die ZrO₂-Teilchen von 5 bis 30 nm.

Die Lösung wird auf ein Substrat 1 aufgetragen. Anschließend werden bei 300°C an Luft die organischen Bestandteile entfernt. Daran anschließend erfolgt eine zweite Beschichtung, die bei 500°C in Gegenwart von Luft 30 Minuten lang behandelt wird. Hierbei entsteht eine poröse Schicht aus einem keramisch-metallischen Komposit. Diese Schicht ist elektrisch leitfähig. Auch bei einer Behandlung bei 400°C verändert sich die Schicht nicht.

Alternativ zu der vorstehend beschriebenen Lösung ist es auch möglich, die Beschichtung zum Beispiel durch Auftragen einer Paste, die 10 Gew.-% Platin und 2 Gew.-% ZrO₂ enthält, zu erzeugen. Das ZrO₂ befindet sich dabei vorzugsweise fein verteilt auf der Oberfläche der Platinteilchen. Hierzu wurde in eine stabilisierte Dispersion von Platinteilchen ZrO₂ in Lösung aus löslichen Vorstufen gefällt. Die Platinteilchen haben bevorzugt einen Durchmesser von 30 bis 100 nm. Als Lösungsmittel eignen sich zum Beispiel Alkohole oder Glykoletherderivate. Die Fällung des ZrO₂ erfolgt zum Beispiel durch Hydrolyse von Zr-Alkoxiden.

Die poröse Schicht 1 kann weiterhin auch hergestellt werden, indem eine Lösung von Platinteilchen in Diethylenglykolmonobutylether eingesetzt wird, deren Durchmesser im Bereich von 20 bis 50 nm liegt. Die Platinteilchen sind mit einer chemisch abgeschiedenen Zr-Metallschicht versehen. Das Verhältnis von Platin zu Zirkon liegt vorzugsweise im Bereich von 5 : 1.

## Patentansprüche

1. Verfahren zur Herstellung einer porösen Schicht (3) auf einem Substrat (1), wobei die poröse Schicht (3) mindestens ein keramisches Material (7) und mindestens ein Metall (9) enthält, folgende Schritte umfassend:
(a) Auftragen einer Dispersion, die mindestens einen Metallbildner und mindestens einen Keramikbildner enthält, auf das Substrat (1), wobei zumindest ein Teil des Metallbildners in Form von Metallpartikeln und/oder zumindest ein Teil des Keramikbildners in Form von Keramikpartikeln in der Dispersion enthalten ist.
(b) Überführen der Dispersion bei einer Temperatur oberhalb von 250°C in eine Cermet-Beschichtung,
wobei sich der Keramikbildner zumindest teilweise an der Oberfläche der Metallpartikel befindet oder der Metallbildner zumindest teilweise an der Oberfläche der Keramikpartikel.

2. Verfahren nach Anspruch 1, **dadurch gekennzeichnet, dass** der Metallbildner zumindest teilweise als mindestens ein Metallsalz oder eine salzartige Vorstufe, die durch die thermische Behandlung in das mindestens eine Metall umgewandelt wird, in der Dispersion enthalten ist.

3. Verfahren nach Anspruch 1, **dadurch gekennzeichnet, dass** der Keramikbildner mindestens ein weiteres Metall ist, welches als Oxid das keramische Material bildet.

4. Verfahren nach Anspruch 1, **dadurch gekennzeichnet, dass** der Keramikbildner ein keramisches Material ist.

5. Verfahren nach einem der vorhergehenden Ansprüche, **dadurch gekennzeichnet, dass** der Keramikbildner und der Metallbildner zumindest teilweise als assoziierter Verband aus Metallpartikeln und Keramikpartikeln vorliegen.

6. Verfahren nach einem der vorhergehenden Ansprüche, **dadurch gekennzeichnet, dass** die Metallpartikel und/oder die Keramikpartikel einen mittleren Durchmesser im Bereich von 5 bis 250 nm aufweisen.

7. Verfahren nach einem der vorhergehenden Ansprüche, **dadurch gekennzeichnet, dass** das mindestens eine Metall ein Metall der 8., 9. oder 10. Gruppe des Periodensystems der Elemente ist.

8. Verfahren nach einem der vorhergehenden Ansprüche, **dadurch gekennzeichnet, dass** die Dispersion mindestens einen Stabilisator oder einen Dispergator enthält.

9. Verfahren nach einem der vorhergehenden Ansprüche, **dadurch gekennzeichnet, dass** die Dispersion mindestens ein Tensid enthält.

10. Verfahren nach einem der vorhergehenden Ansprüche, **dadurch gekennzeichnet, dass** die Dispersion mindestens einen Porenbildner enthält.

11. Verfahren nach einem der vorhergehenden Ansprüche, **dadurch gekennzeichnet, dass** der Anteil an Metallbildner und Keramikbildner in der Dispersion im Bereich von 0,1 bis 5 Vol.-% bei einer flüssigen Dispersion oder im Bereich von 5 bis 60 Vol.-% bei einer pastösen Dispersion liegt.

12. Verfahren nach einem der vorhergehenden Ansprüche, **dadurch gekennzeichnet, dass** der Anteil des keramischen Materials in der Dispersion im Bereich von 1 bis 40 Vol.-% liegt.

13. Verfahren nach einem der vorhergehenden Ansprüche, **dadurch gekennzeichnet, dass** das Substrat (1) ein Feldeffekttransistor und die poröse Schicht (3) eine Gateelektrode ist.

## Claims

1. Process for producing a porous layer (3) on a substrate (1), where the porous layer (3) contains at least one ceramic material (7) and at least one metal (9), which comprises the following steps:
(a) application of a dispersion containing at least one metal former and at least one ceramic former to the substrate (1), where at least part of the metal former is present in the form of metal particles and/or at least part of the ceramic former is present in the form of ceramic particles in the dispersion,
(b) conversion of the dispersion into a cermet coating at a temperature above 250°C,
where the ceramic former is located at least partly on the surface of the metal particles or the metal former is located at least partly on the surface of the ceramic particles.

2. Process according to Claim 1, **characterized in that** the metal former is present at least partly as at least one metal salt or a salt-like precursor which is converted by the thermal treatment into the at least one metal in the dispersion.

3. Process according to Claim 1, **characterized in that** the ceramic former is at least one further metal which forms the ceramic material as oxide.

4. Process according to Claim 1, **characterized in that** the ceramic former is a ceramic material.

5. Process according to any of the preceding claims, **characterized in that** the ceramic former and the metal former are present at least partly as associated agglomerate of metal particles and ceramic particles.

6. Process according to any of the preceding claims, **characterized in that** the metal particles and/or the ceramic particles have an average diameter in the range from 5 to 250 nm.

7. Process according to any of the preceding claims, **characterized in that** the at least one metal is a metal of group 8, 9 or 10 of the Periodic Table of the Elements.

8. Process according to any of the preceding claims, **characterized in that** the dispersion contains at least one stabilizer or dispersant.

9. Process according to any of the preceding claims, **characterized in that** the dispersion contains at least one surfactant.

10. Process according to any of the preceding claims, **characterized in that** the dispersion contains at least one pore former.

11. Process according to any of the preceding claims, **characterized in that** the proportion of metal former and ceramic former in the dispersion is in the range from 0.1 to 5% by volume in the case of a liquid dispersion or in the range from 5 to 60% by volume in the case of a paste-like dispersion.

12. Process according to any of the preceding claims, **characterized in that** the proportion of the ceramic material in the dispersion is in the range from 1 to 40% by volume.

13. Process according to any of the preceding claims, **characterized in that** the substrate (1) is a field effect transistor and the porous layer (3) is a gate electrode.

## Revendications

1. Procédé pour la fabrication d'une couche poreuse (3) sur un substrat (1), dans lequel la couche poreuse (3) contient au moins un matériau céramique (7) et au moins un métal (9), comprenant les étapes suivantes:
a) dépôt d'une dispersion, qui contient au moins un formateur de métal et au moins un formateur de céramique, sur le substrat (1), dans lequel au moins une partie du formateur de métal est contenue sous la forme de particules de métal et/ou au moins une partie du formateur de céramique est contenue sous la forme de particules de céramique dans la dispersion,
b) transformation de la dispersion en une couche de cermet à une température supérieure à 250°C,
dans lequel le formateur de céramique se trouve au moins en partie à la surface des particules de métal ou le formateur de métal se trouve au moins en partie à la surface des particules de céramique.

2. Procédé selon la revendication 1, **caractérisé en ce que** le formateur de métal est contenu dans la dispersion au moins en partie sous la forme d'au moins un sel métallique ou d'un précurseur de type sel, qui est converti en ledit au moins un métal par le traitement thermique.

3. Procédé selon la revendication 1, **caractérisé en ce que** le formateur de céramique est au moins un autre métal, qui forme le matériau céramique sous forme d'oxyde.

4. Procédé selon la revendication 1, **caractérisé en ce que** le formateur de céramique est un matériau céramique.

5. Procédé selon l'une quelconque des revendications précédentes, **caractérisé en ce que** le formateur de céramique et le formateur de métal se trouvent au moins en partie sous la forme d'un ensemble associé de particules de métal et de particules de céramique.

6. Procédé selon l'une quelconque des revendications précédentes, **caractérisé en ce que** les particules de métal et/ou les particules de céramique présentent un diamètre moyen de l'ordre de 5 à 250 nm.

7. Procédé selon l'une quelconque des revendications précédentes, **caractérisé en ce que** ledit au moins un métal est un métal du groupe 8, 9 ou 10 du système périodique des éléments.

8. Procédé selon l'une quelconque des revendications précédentes, **caractérisé en ce que** la dispersion contient un moins un stabilisant ou un dispersant.

9. Procédé selon l'une quelconque des revendications précédentes, **caractérisé en ce que** la dispersion contient au moins un tensioactif.

10. Procédé selon l'une quelconque des revendications précédentes, **caractérisé en ce que** la dispersion contient au moins un formateur de pores.

11. Procédé selon l'une quelconque des revendications précédentes, **caractérisé en ce que** la part du formateur de métal et du formateur de céramique dans la dispersion se situe dans la plage de 0,1 à 5 % en volume dans le cas d'une dispersion liquide ou dans la plage de 5 à 60 % en volume dans le cas d'une dispersion pâteuse.

12. Procédé selon l'une quelconque des revendications précédentes, **caractérisé en ce que** la part du matériau céramique dans la dispersion se situe dans la plage de 1 à 40 % en volume.

13. Procédé selon l'une quelconque des revendications précédentes, **caractérisé en ce que** le substrat (1) est un transistor à effet de champ et la couche poreuse (3) est une électrode de grille.
